# EUROPEAN PATENT APPLICATION

(11) **EP 1 814 162 A1**
(43) Date of publication of application: **01.08.2007**
(21) Application number: 05788237.5
(22) Date of filing: 30.09.2005
(51) Int. Cl.: H01L 29/78, H01L 29/06, H01L 29/12, H01L 21/336

(54) **SILICON CARBIDE MOS FIELD-EFFECT TRANSISTOR AND PROCESS FOR PRODUCING THE SAME**

(30) Priority: 18.11.2004 JP 2004334920
(71) Applicant: National Institute of Advanced Industrial Science and Technology, Tokyo 100-8921 (JP)
(72) Inventor: YATSUO, Tsutoma, Tsukuba Central, Ibaraki 3058568 (JP); HARADA, Shinsuke, Tsukuba Central, Ibaraki 3058568 (JP); OKAMOTO, Mitsuo, Tsukuba Central, Ibaraki 3058568 (JP); FUKUDA, Kenji, Tsukuba Central, Ibaraki 3058568 (JP)
(74) Representative: Smith, Norman Ian
(86) International application number: PCT/JP2005/018104
(87) International publication number: WO 2006/054394

(57) **Abstract**

In the SiC vertical MOSFET having a low-concentration p-type deposition film provided therein with a channel region and a base region resulting from reverse-implantation to n-type through ion implantation, dielectric breakdown of gate oxide film used to occur at the time of off, thereby preventing a further blocking voltage enhancement. This problem has been resolved by interposing of a low-concentration n-type deposition film between a low-concentration p-type deposition film and a high-concentration gate layer and selectively forming of a base region resulting from reverse-implantation to n-type through ion implantation in the low-concentration p-type deposition film so that the thickness of deposition film between the high-concentration gate layer and each of channel region and gate oxide layer is increased.

## Description

### Technical Field:

This invention relates to the configuration of a vertical MOSFET having a low On-resistance and a high voltage and using silicon carbide as raw material and a method for producing the same.

### Background Art:

The single crystal of silicon carbide (SiC) possesses excellent solid state properties, such as a wide band gap, high dielectric breakdown strength and a large saturation drift velocity of electrons as compared with the single crystal of silicon (Si). By using SiC as a starting material, therefore, it is rendered possible to fabricate a semiconductor device for use with an electrical power of high blocking voltage and low resistance exceeding the limits on Si. SiC is further characterized by being capable of forming an insulating layer by thermal oxidation similarly to Si. These facts lead to a supposition that the fabrication of a vertical MOSFET having a high blocking voltage and a low On-resistance and using the single crystal of SiC as a raw material is feasible. Numerous researches and developments directed to this fabrication have been under way.

When SiC is used as a raw material, the vertical MOSFET cannot be fabricated by the double diffusion method that is generally applied to Si. This is because the diffusion coefficients of impurity elements are extremely small in the crystal of SiC and the formation of channel regions is consequently precluded by the difference in transverse diffusion length between the p-type and n-type impurities. Thus, the vertical MOSFET similar to the D-MOSFET of Si is fabricated by the ion implantation of p-type and n-type impurities. This method, however, degrades electron mobility because numerous crystal defects induced by ion implantation remain in the channel region and scatter the conduction electrons induced in the channel. The SiC vertical MOSFET fabricated by the double ion implantation method has channel mobility of not more than 5 cm²/Vs, an extremely small value as compared with the channel mobility of about 500 cm²/Vs exhibited by the Si D-MOSFET. As a result, the product entails the problem that the On-resistance is far higher than the theoretical value thereof.

As a means to solve this problem, the configuration that forms the channel region not by ion implantation but with a deposition film has been proposed. A typical example of this configuration is disclosed in Japanese Patent Application No. 2002-304596 that was filed on October 18, 2002. FIG. 7 is a cross section of the unit cell of this configuration. In this configuration, a low-concentration n-type drift layer 2 is deposited on a high-concentration n-type substrate 1, a high-concentration p-type gate layer 31 is formed by ion implantation on the surface of the n-type drift layer 2, and a low-concentration p-type layer 32 is deposited further thereon. On the surface part of the low-concentration p-type layer 32, an n-type source layer 5 is selectively formed by ion implantation, a gate electrode 7 is formed via a gate oxide film 6, and further a source electrode 9 is formed via an interlayer insulation film 8. A channel region 11 is formed in the low-concentration p-type deposition layer 32 directly below the gate oxide film 6. The configuration is characterized by the fact that an n-type base layer 4 piercing through the low-concentration p-type deposition layer 32 and reaching the n-type drift layer 2 is selectively formed by the ion implantation of an n-type impurity from the surface (hereinafter the n-type base layer 4 will be occasionally referred to as "reverse-implanted layer"). Since this configuration has the channel region 11 formed in the low-concentration p-type deposition layer that has undergone no ion implantation, it is capable of acquiring high mobility of conduction electrons and permitting fabrication of a vertical MOSFET having a small On-resistance. It is further characterized by the fact that the leak of an electric field as into the gate oxide film in the neighborhood of the channel region 11 can be prevented and the source and drain blocking voltage can be heightened because the depletion layer transversely extending from the high-concentration p-type gate layer 31 to the low-concentration n-type drift layer 2 in the state of voltage inhibition enables the vertical channel part 24 to be completely pinched off with low voltage.

Even this configuration, however, entails problems that inhibit efforts directed toward further adding to blocking voltage and lowering On-resistance as described below. One of the problems is that the depletion layer is also extended upwardly in the n-type base layer 4 (reverse-implanted layer) till the vertical channel part 24 is completely pinched off by the depletion layer extending transversely from the high-concentration p-type gate layer 31 to the low-concentration n-type drift layer 2 in the state of blocking voltage. When the reverse-implanted layer has a low impurity concentration and a small thickness, the depletion layer reaches the interface with the gate oxide film 6 and the gate oxide film intervening between the gate electrode 7 and the n-type base layer 4 is exposed to a strong electric field and suffered to induce dielectric breakdown before the vertical channel part is completely pinched off. The problem that this electric field gains in intensity in consequence of the increase of voltage even after the vertical channel part is pinched off and the dielectric breakdown of the gate oxide film in this part restrains the blocking voltage between the source and the drain to a low level also persists.

While the electron mobility in the channel is expected to assume a large value because the channel region 11 is formed in the low-concentration p-type deposition film 32, it actually does not grow so large as expected for the following reason. Specifically, the low-concentration p-type deposition film 32 is formed directly on the p-type gate layer 31 having ions implanted therein till a high concentration. The deposition film on the layer exposed to implantation effected in such a high concentration as this is liable to have the solid-state properties thereof as a single crystal film conspicuously impaired. Particularly when the deposition film has a small thickness, the electron mobility in the film is prevented from growing large owing to the conspicuous influence of the substrate.

It is considered that the problem inhibiting an effort directed toward further increasing blocking voltage and decreasing On-resistance of the vertical MOSFET using SiC as the raw material and adopting the conventionally proposed configuration consisting in disposing the channel region in the low-concentration p-type deposition film and reverse-implanting the part of the deposition film to an n-type by selective ion implantation, thereby forming an electron passage can be avoided by thickening the low-concentration p-type deposition film 32 to more than a certain degree. For this addition to the thickness of the deposition film enables a thick n-type base layer 4 to lower the electric field exerted on the gate oxide film and as well allows the channel region to be formed in the deposition film of high quality separated more from the highly implanted layer.

The vertical MOSFET configuration proposed heretofore, however, is incapable of forming the low-concentration p-type deposition film in an increased thickness owing to the restriction imposed on the process followed in the fabrication thereof. Specifically, as described in paragraph [0004], the method for fabricating the vertical MOSFET in the conventional configuration forms the n-type base layer 4 by reversing (reverse-implanting) the low-concentration p-type deposition film 32 to an n-type one by the ion implantation of an n-type impurity pierced via the surface of the film. Incidentally, the thickness in which the film can be reverse-implanted by the ion implantation has its own limit Though the depth to which ions are implanted depends on the ion acceleration voltage, it is approximately 1 µm at most with the acceleration voltage (several hundred keV to 1000 keV) in common use. The thickness of the reverse-implanted layer (which equals the thickness of the p-type deposition film), therefore, is generally restricted approximately to 0.5 to 0.7 µm. Any further addition to this thickness is difficult to obtain.

### Disclosure of the Invention:

### Problem to be solved by the Invention:

The SiC vertical MOSFET entails the problem that the channel mobility is small as compared with the Si-MOSFET and the On-resistance is not lowered. In contrast, the vertical MOSFET of the configuration having a channel region formed of a low-concentration p-type deposition film enables addition to the channel mobility and is therefore expected to be effective in decreasing the On-resistance. The configuration proposed heretofore causes the conduction type of the low-concentration p-type deposition film to be reverse-implanted from the p type to the n type by the ion implantation. Since the deposition film that can be reverse-implanted, therefore, has the thickness thereof restricted to a small size, it has not been enabled to acquire fully high crystal quality in the channel region and thickness large enough to alleviate an electric field in the state blocking voltage. As a result, it entails the problem that it cannot retain a high ability to block higher voltage and the problem that it does not lower the On-resistance as expected.

In view of these problems, this invention is aimed at realizing an SiC vertical MOSFET possessing low On-resistance and high blocking voltage and providing a new configuration of SiC vertical MOSFET possessing a channel region formed of a low-concentration p-type deposition film.

Another object of this invention is to in provide a method for the fabrication of a high-blocking-voltage SiC vertical MOSFET possessing a channel region formed of a low-concentration p-type deposition layer.

Yet another object of this invention is to provide a configuration that enables a high-blocking-voltage SiC vertical MOSFET possessing a channel region formed of a low-concentration p-type deposition layer to be fabricated in a high yield and a method for the fabrication thereof.

### Means to solve the Problem

For the purpose of solving the problems mentioned above, this invention, as a means to heighten the blocking voltage and lower the On-resistance of the SiC vertical MOSFET having a low-concentration channel region formed in a low-concentration p-type deposition layer, contemplates interposing a high-concentration p-type layer and a low-concentration n-type deposition layer between the low-concentration p-type deposition layer and an n-type drift layer and causing the low-concentration n-type deposition layer to contact directly the high-concentration p-type layer and as well contact directly the n-type drift layer in a partial depletion part provided in the high-concentration p-type layer.

In the SiC vertical MOSFET of the foregoing configuration, each of the low-concentration p-type deposition layer and the low-concentration n-type deposition layer is formed of two stacked films.

The method for fabricating this SiC vertical MOSFET comprises the steps of forming the high-concentration p-type layer on part of the n-type drift layer, forming the low-concentration n-type deposition film on the high-concentration p-type layer and as well on the n-type drift layer exposed in the partial depletion part, forming a low-concentration p-type deposition film thereon, and further carrying out selective ion implantation of a slightly high concentration n-type impurity in the neighborhood to which the partial depletion part is projected in the direction of thickness and the region encircling the neighborhood till the implantation passes through the low-concentration p-type deposition film and reaches the low-concentration n-type deposition film, thereby reversing (reverse-implanting) the part of the low-concentration p-type deposition film and forming an n-type base region. By so doing, the low-concentration p-type deposition film is enabled solely to suffice the formation of the region that must be permeated by ion implantation and consequently reverse-implanted to the n-type. Consequently, the low-concentration p-type deposition film and the low-concentration n-type deposition film interposed between the high-concentration p-type layer and the n-type drift layer of the partial depletion part have no restriction imposed on thickness by reason of the kind of process but are allowed to possess ample thickness. As a result, the problem that the depleting layer reaches the interface thereof with the gate oxide film 6 before the vertical channel part is completely pinched off, exerts a strong electric field on the gate oxide film interposed between the gate electrode 7 and the n-type base region 4 and induces dielectric breakdown (the problem described in paragraph [0005]) and the problem that the electron mobility in the deposition film is prevented by the prominent influence of the substrate from growing when this film has a small thickness (the problem described in paragraph [0006]) can be solved.

### Effect of the Invention:

As described above, this invention manifests the following effect.
The inventions set forth in claim 1 and claim 2 enable realizing an SiC vertical MOSFET exhibiting low On-resistance and high blocking voltage by providing the low-concentration p-type deposition layer therein with a low-concentration channel region and interposing a comparatively thick deposition film between the gate oxide film and the high-concentration gate layer. The vertical MOSFET having a high blocking voltage of not less than 1500 V can be realized by properly selecting the impurity concentration and the thickness of an interposed n-type deposition layer (33).
The inventions set forth in claim 3 and claim 6 allow forming a second conduction type high-concentration gate layer with high accuracy and therefore facilitating refinement of cells and, consequently, enable increasing blocking voltage and decreasing loss of the SiC vertical MOSFET.
The inventions set forth in claim 4 and claim 6 relate to a configuration that invariably has a deposition film stacked on a deposition film and a method for the fabrication thereof and consequently allow enhancing the crystal quality of the channel region and decreasing the On-resistance of the SiC vertical MOSFET.
The invention set forth in claim 5 enables easy fabrication of the vertical MOSFET that exhibits high blocking voltage and low On-resistance.
The invention set forth in claim 8 allows improving the uniformity of an electric current in motion in the ON state and as well refining the cell to a size of about 15 µm owing to the effect of one kind of self-alignment action and therefore enables substantially decreasing the On-resistance of the vertical MOSFET.
The inventions set forth in claim 9 and claim 10 realizes such a vertical MOSFET as exhibits suppressed leak current and heightened blocking voltage by removing a leak path for an electric current in the OFF state.
The invention set forth in claim 11 realizes such a SiC vertical MOSFET as exhibits small On-resistance and high blocking voltage.

### Brief Description of the Drawings:

[FIG. 1] It is a cross section of the unit cell of an SiC vertical MOSFET in Embodiment 1 of this invention.
[FIG. 2a] (a) to (f) are cross sections of the cell varying during the process of fabrication of the SiC vertical MOSFET in Embodiment 1 of this invention.
[FIG. 2b] (g) to (k) are cross sections of the cell varying during the process of fabrication of the SiC vertical MOSFET in Embodiment 1 of this invention.
[FIG. 3] It is a cross section of the unit cell of a SiC vertical MOSFET in Embodiment 2 of this invention.
[FIG. 4] It is a cross section of the unit cell of a SiC vertical MOSFET in Embodiment 3 of this invention.
[FIG. 5] (d) to (f) are cross sections of part of the process for fabricating a SiC vertical MOSFET in Embodiment 3 of this invention.
[FIG. 6] It is a cross section of the unit cell of a SiC vertical MOSFET in Embodiment 4 of this invention.

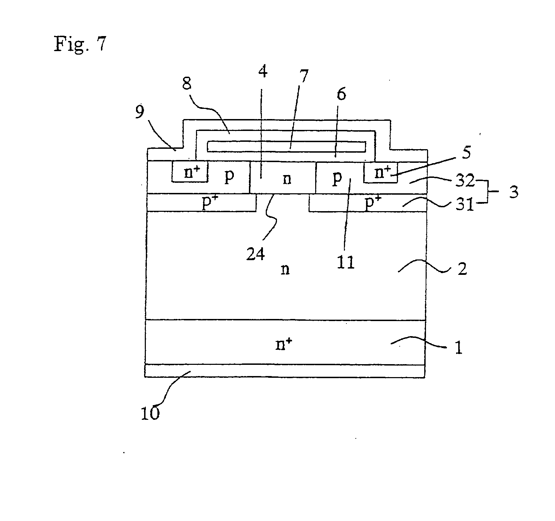

[FIG. 7] It is a cross section of the unit cell of a SiC vertical MOSFET representing prior art.

### Explanation of Reference Numerals:

- 1.: High-concentration n-type substrate
- 2.: Low-concentration n-type drift layer
- 3.: p-Well layer
- 3a.: p-Type impurity ion implantation
- 4.: n-Type base region
- 4a.: n-Type impurity ion implantation
- 5.: n-Type source layer
- 5a.: n-Type impurity ion implantation
- 6.: Gate insulation film
- 6a.: p-Type impurity ion implantation
- 7.: Gate electrode
- 8.: Interlayer insulation film
- 9.: Source electrode
- 10.: Drain electrode
- 11.: Channel region
- 13.: Ion implantation mask
- 14.: Ion implantation mask
- 16.: Ion implantation mask
- 24.: Partial depletion part of p-type layer
- 31.: High-concentration p-type layer
- 32.: Low-concentration p-type layer
- 33.: Low-concentration n-type layer
- 34.: High-concentration p-type layer
- 40.: Window in ion implantation mask
- 41.: High-concentration n-type layer
- 50.: Trench
- 51.: Insulation film

### Best Mode for carrying out the Invention:

Now, this invention will be described in detail below by reference to concrete embodiments.

### [Embodiment 1]

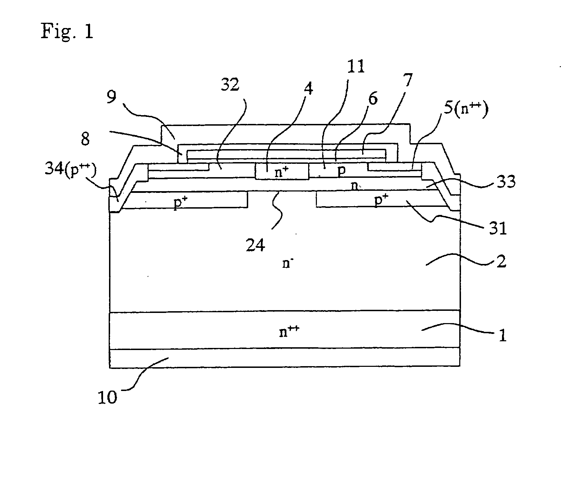

FIG. 1 is a cross section of the unit cell of a SiC vertical MOSFET in Embodiment 1 of this invention. In this configuration, an n-type drift layer 2 doped with nitrogen in a concentration of 5 x 10¹⁵ cm⁻³ is deposited in a thickness of 15 µm on an n-type SiC substrate 1 doped with nitrogen in a concentration of 5 x 10¹⁸ cm⁻³ and having a thickness of about 300 µm. A p-type layer 31 doped with aluminum in a concentration of 2 x 10¹⁸ cm⁻³ is formed across a depth of 0.5 µm from the surface thereof and the p-type layer 31 is provided with a partial depletion part 24 having a width of about 2.0 µm. An n-type layer 33 doped with nitrogen in a concentration of 1 x 10¹⁶ cm⁻³ is deposited in a thickness of 1.0 µm on the surface of the p-type layer 31 and the surface of the n-type drift layer 2 of the partial depletion part 24 and a p-type layer 32 doped with aluminum in a concentration of 5 x 10¹⁵ cm⁻³ is deposited in a thickness of 0.5 µm on the surface of the n-type layer 33. On the surface part of this p-type layer 32, an n-type source layer 5 doped with phosphorus in a concentration of about 1 x 10²⁰ cm⁻³ is selectively formed. In the part of the p-type layer 32 in the neighborhood to which the partial depletion part 24 is projected in the direction of thickness, an n-type base region 4 doped with nitrogen in a concentration of 1 x 10¹⁶ cm⁻³ or more and having a depth of about 0.7 µm is formed to a depth reaching the n-type layer 33 past the p-type layer 32. A channel region 11 is formed on the surface layer of the p-type layer 32 in the middle part between the n-type base region 4 and the n-type source layer 5. A gate electrode 7 is disposed via a gate insulation film 6 on the channel region 11 and in the part on the surface of the n-type base region 4 and the n-type source layer 5, and a source electrode 9 connected in low resistance to the surface of the n-type source layer 5 is formed via an interlayer insulation film 8 on the gate electrode 7. The source electrode 9 is further made to form a p-n junction with the n-type layer and is connected in low resistance also to the surface of a p⁺ layer 34 formed jointly over the p-type layer 32 and the p-type layer 31 and doped with aluminum in a concentration of about 1 x 10¹⁹ cm⁻³. On the back surface of the high-concentration n-type substrate 1, a drain electrode 10 is formed as connected in low resistance. Incidentally, the gate oxide film 6 and the gate electrode 7 formed on the surface of the n-type base region 4 are occasionally excluded.

The operation of this SiC vertical MOSFET is basically similar to that of an ordinary Si vertical MOSFET. Specifically, in the ON state, electrons are induced and the channel region 11 is formed on the surface of the p-type layer 32 when a gate voltage exceeding the threshold voltage is applied to the gate electrode 7. Consequently, the n-type source layer 5 and the n-type drift layer 2 are joined with an electron-carrying passage through the channel region 11, n-type base region 4, n-type layer 33 and partial depletion part 24, and an electric current is passed from a drain electrode 10 to the source electrode 9. In this configuration, the channel region 11 is formed in a p-type deposition film having a low concentration of 5 x 10¹⁵ cm⁻³ and as well on the surface layer separated by 1 µ or more from the p-type layer 31 via the n-type layer 33 deposited in a thickness of 1.0 µm between the p-type deposition film and the high-concentration p-type layer and via the p-type layer 32 deposited in a thickness of 0.5 µm. Thus, even when the p-type layer 31 happens to be a layer formed by high-concentration ion implantation and consequently made to contain numerous crystal defects, it is rendered possible to impart satisfactorily high crystal quality to the film of the part deposited thickly thereon, acquire a high channel mobility of several 10 cm²/Vs and decrease the On-resistance.

Then, in the OFF state, while the voltage applied between the drain and source electrodes is inhibited by the p-n junction formed between the high-concentration p-type layer 31 and the n-type drift layer 2, the lateral part of MOSFET composed of the n-type base region 4, p-type layer 32, n-type source layer 5, gate oxide film 6 and gate electrode 7 serves to inhibit the voltage till the partial depletion part 24 of the p-type layer 31 is completely pinched off by the depletion layer extended from the p-n junction. Since the partial depletion part 24 of the p-type layer 31 has a width of 2 µm and the n-type drift layer 2 has a doping concentration of 5 x 10¹⁵ cm⁻³ and consequently the pinch-off voltage falls in the range of 30 to 50 V, the lateral part of MOSFET is capable of withstanding such a low voltage as this. The conventional problem that even after completion of the pinch-off in the partial depletion part, application of a higher voltage causes the gate oxide film of the lateral MOSFET to incur dielectric breakdown due to leakage electric field can be eliminated by the alleviation of the electric field by the n-type layer 33 intervening between the partial depletion part 24 and the n-type base region 4. The present embodiment could acquire an inhibition voltage of 1500 V. Incidentally, the impurity concentration and the thickness of the n-type layer 33 do not need to be limited to the values specifically indicated in the present embodiment, but may be altered in any way by the inhibition voltage of the SiC vertical MOSFET to be designed.

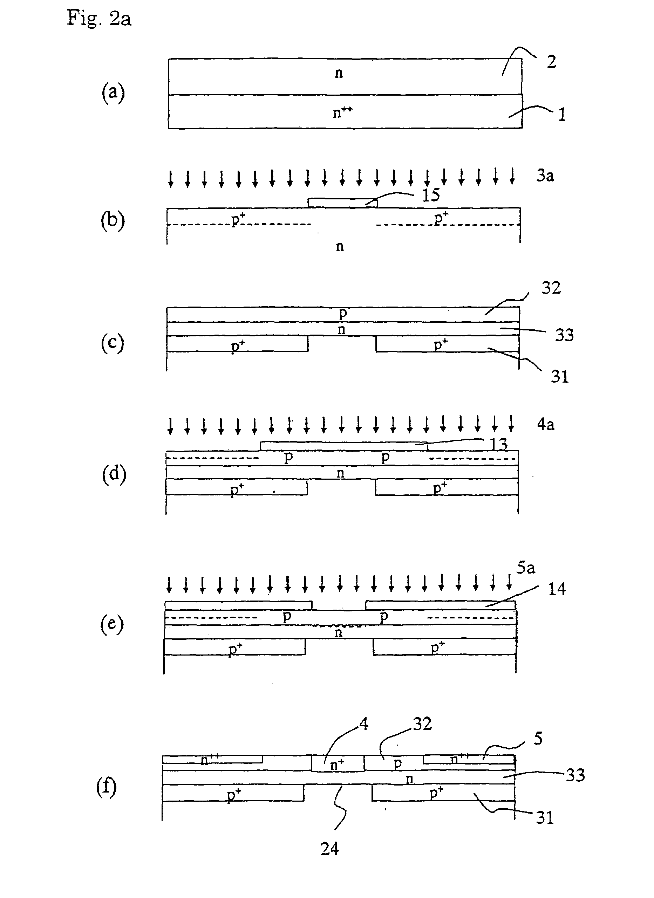

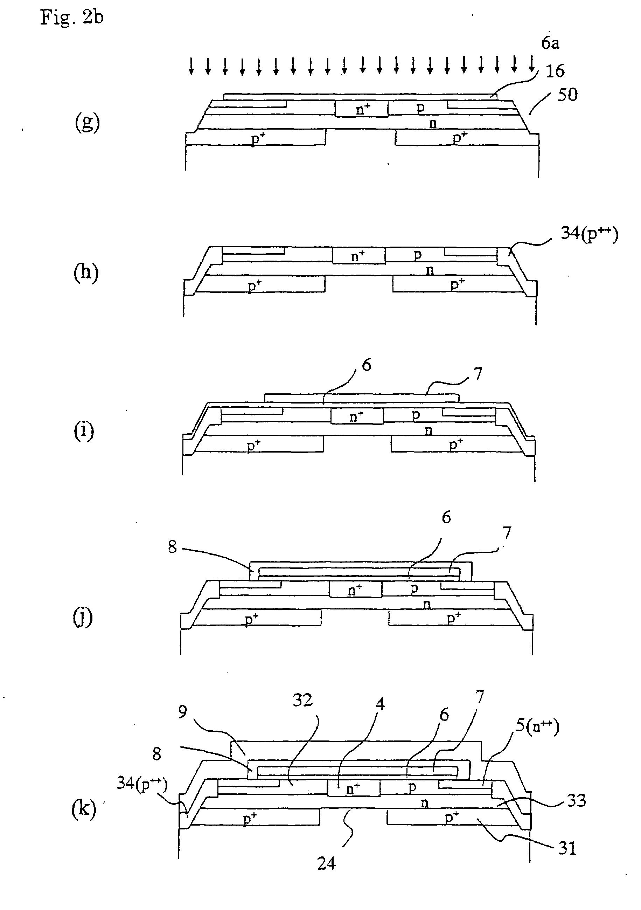

FIG. 2a(a) to FIG. 2a(f) and FIG. 2b(g) to FIG. 2b(k) are diagrams illustrating the process for fabricating the SiC vertical MOSFET in Embodiment 1 of this invention. They severally depict a cross section of the unit cell. First, on the high-concentration n-type substrate 1, the low-concentration n-type drift layer 2 doped with nitrogen in a concentration of 5 x 10¹⁵ cm⁻³ was deposited in a thickness of 15 µm (a). Then, for the purpose of forming the high-concentration p-type layer 31, a p-type impurity ion implantation 3a using a mask 15 was carried out (b). The mask 15 was formed by causing an SiO₂ film deposited in a thickness of 1 µm by the low-pressure CVD method on the surface to be patterned by photolithography. The p-type impurity ion implantation 3a was implemented by subjecting aluminum ions to such conditions as 500°C in substrate temperature, 40 keV to 250 keV in accelerated energy and 2 x10¹⁸ cm⁻³ in amount of implantation. On the surface stripped of the mask, the low-concentration n-type layer 33 doped with phosphorus in a concentration of 1 x 10¹⁶ cm⁻³ was deposited in a thickness of 1.0 µm and subsequently the low-concentration p-type layer 32 doped with aluminum in a concentration of 5 x 10¹⁵ cm⁻³ was deposited in a thickness of 0.5 µm (c). Thereafter, for the purpose of forming the n-type source region 5, an n- type impurity ion implantation 4a using a mask 13 was carried out (d). The n-type impurity ion implantation 4a was implemented by subjecting phosphorus ions to such conditions as 500°C in substrate temperature, 40 keV to 250 keV in accelerated energy and 2 x10²⁰ cm⁻³ in amount of implantation. After the mask 13 was removed, an n-type impurity ion implantation 5a using a mask 14 was carried out for the purpose of forming the n-type base region 4 (e). The n-type impurity ion implantation 5a was implemented by subjecting nitrogen ions to such conditions as room temperature, 40 keV to 250 keV in accelerated energy and 1 x10¹⁶ cm⁻³ in amount of implantation. After the mask 14 was removed, an activation anneal was carried out in an atmosphere of argon at 1500°C for 30 minutes (f). This treatment resulted in forming the p-type layer 32, n⁺ base layer 4 and n-type source layer 5. Subsequently, a trench 50 extending from the n-type source layer 5 to the p-type layer 31 was incised by dry selective etching (g) and then a p-type impurity ion implantation 6a using a mask 16 was carried out. The p-type impurity ion implantation 6a was implemented by subjecting aluminum ions to such conditions as 500°C in substrate temperature, 40 keV to 50 keV in accelerated energy and 2 x10¹⁸ cm⁻³ in amount of implantation. This treatment resulted in forming the p⁺ layer 34 doped with aluminum in a high concentration of about 1 x 10¹⁹ cm⁻³ (h). Subsequently, the gate insulation film 6 having a thickness of 40 mm was formed by thermal oxidation performed at 1200°C for 140 minutes and the gate electrode 7 was formed thereon by depositing thereon polycrystalline silicon in a thickness of 0.3 µm by the low-pressure CVD method and patterning this silicon by photolithography (i). Further, the interlayer insulation film 8 was deposited in a thickness of 0.5 µm on the surface by the low-pressure CVD method and a window was inserted in the interlayer insulation film 8 (i), and a source electrode 9 for common use by the n-type source layer 5 and the high-concentration p⁺ layer 34 was formed to complete the device aimed at.

### [Embodiment 2]

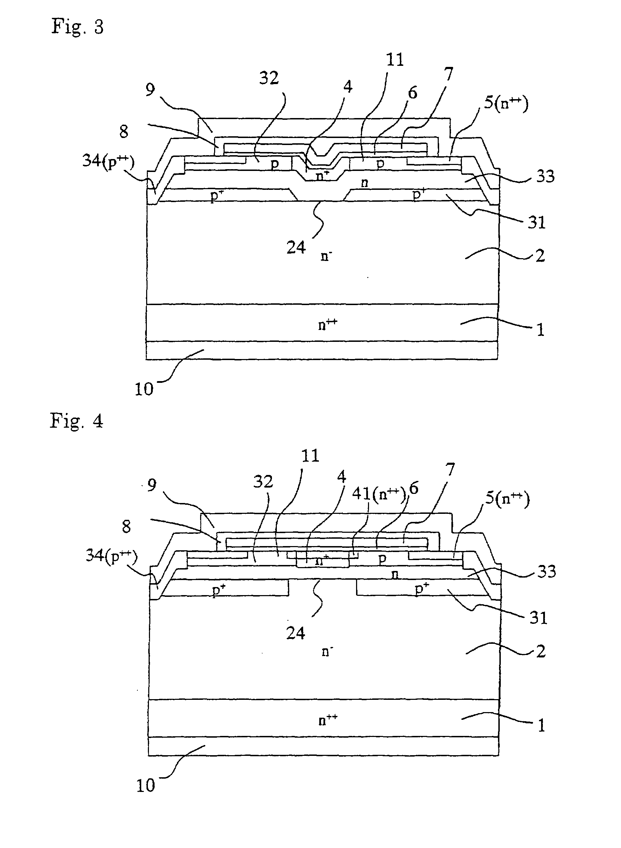

FIG. 3 is a cross section of the unit cell of an SiC vertical MOSFET in Embodiment 2 of this invention. In this configuration, the n-type drift layer 2 doped with nitrogen in a concentration of 5 x 10¹⁵ cm⁻³ was deposited in a thickness of 15 µm on the substrate 1 doped with nitrogen in a concentration of 5 x 10¹⁸ cm⁻³ and having a thickness of about 300 µm. The p-type layer 31 doped with aluminum in a concentration of 2 x 10¹⁸ cm⁻³ was deposited in a thickness of 0.5 µm on the resultant surface, and the p-type layer 31 was provided with a partial depletion part 24 having a width of about 2.0 µm. On the surface of the p-type layer 31 and the surface of the n-type drift layer 2 of the partial depletion part 24, the n-type layer 33 doped with nitrogen in a concentration of 1 x 10¹⁶ cm⁻³ was deposited in a thickness of 1.0 µm. Further, on the surface of the n-type layer 33, the p-type layer 32 doped with aluminum in a concentration of 5 x 10¹⁵ cm⁻³ was deposited in a thickness of 0.5 µm. On the surface part of the p-type layer 32, the n-type source layer 5 doped with phosphorus in a concentration of about 1 x 10²⁰ cm⁻³ was selectively formed. In the part of the p-type layer 32 in the neighborhood to which the partial depletion part 24 was projected in the direction of thickness, the n-type base region 4 doped with nitrogen in a concentration of 1 x 10¹⁶ cm⁻³ or more and having a depth of about 0.7 µm was formed by ion implantation to a depth reaching the n-type layer 33 past the p-type layer 32. The channel region 11 was formed in the surface layer of the p-type layer 32 in the middle part between the n-type base region 4 and the n-type source layer 5. In the part on the channel region 11 and on the surfaces of the n-type base region 4 and the n-type source layer 5, the gate electrode 7 was formed via the gate insulation film 6. On the gate electrode 7, the source electrode 9 connected in low resistance to the surface of the n-type source layer 5 was formed via the interlayer insulation film 8. Further, the source electrode 9 was made to form a p-n junction with the n-type layer and was as well connected in low resistance to the surface of the p⁺ layer 34 formed jointly over the p-type layer and the p-type layer and doped with aluminum in a high concentration of about 1 x 10¹⁹ cm⁻³. On the back surface of the high-concentration n-type substrate 1, the drain electrode 10 was formed as connected thereto in low resistance. Incidentally, the gate oxide film 6 and the gate electrode 7 that are formed on the surface of the n-type base region 4 are occasionally omitted.

This SiC vertical MOSFET and Embodiment 1 of FIG. 1 differed in respect that the p-type layer 31 was not formed in the n-type drift layer 2 by ion implantation, but was formed as a deposition film on the surface of the n-type drift layer 2 and that the partial depletion part 24 was provided by removing part of the p-type layer 31 by etching. Embodiment 1 was at an advantage in being liable to acquire high electron mobility as compared with Embodiment 2 because the p-type layer 31 was formed not by ion implantation but with a deposition film resulting as from epitaxial growth, and the crystal films of the n-type layer 33 and the p-type layer 32 deposited thereon could not be appreciably impaired.

### [Embodiment 3]

FIG. 4 is a cross section of the SiC vertical MOSFET in Embodiment 3 of this invention. In the drawing, the sites bearing the same reference numerals as in FIG. 1 designate the same parts and the basic configuration is identical with that of Embodiment 1 of FIG. 1 except that a high-concentration n-type layer 41 is disposed as parted on the opposite sides of the n-type base region 4. The high-concentration n-type layer 41 was simultaneously formed with the n-type source layer 5 and was equaled therewith in impurity concentration and depth from the surface and was given a length substantially equal to the partial depletion part 24. The provision of this layer was effective in preventing refinement of cells and concentration of an electric current because it enabled equalizing the two channel regions 11 contained in the unit cell in terms of length and imparting a prescribed relation to their relative positions. This operational effect may be well comprehended from the method of fabrication that will be described herein below.

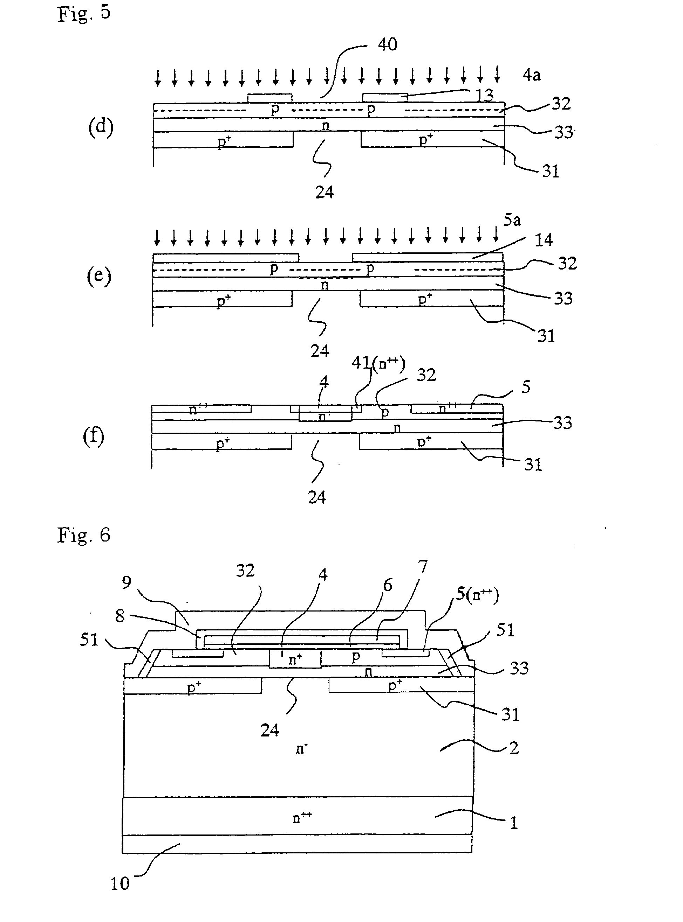

FIG. 5(d) through FIG. 5(f) are diagrams illustrating a part of the process for fabricating an SiC vertical MOSFET in Embodiment 3 of this invention. This embodiment used the steps of FIG. 5(d) through FIG. 5(f) in the place of the steps of FIG. 2a(d) through FIG. 2a(f) in the process for the fabrication of the SiC vertical MOSFET in Embodiment 1 of this invention and used the same steps in the rest of the process. That is, at the step of FIG. 5(d), the mask 13 adapted to form the n-type source region 5 by the n-type impurity ion implantation 4a was provided at a position of the p-type layer 31 in the neighborhood to which the partial depletion part 24 was projected perpendicularly with a window 40 having substantially the same width as the partial depletion part 24 and this window was utilized for ion implantation (d). The n-type impurity ion implantation 4a was implemented by subjecting phosphorus ions to such conditions as 500°C in substrate temperature, 40 keV to 250 keV in accelerated energy and 2 x 10²⁰ cm⁻³ in amount of implantation. After the mask 13 was removed, the n-type impurity ion implantation 5a using the mask 14 was carried out for the purpose of forming the n-type base region 4 (e). The n-type impurity ion implantation 5a was implemented by subjecting nitrogen ions to such conditions as room temperature, 40 keV to 250 keV in accelerated energy and 1 x 10¹⁶ cm⁻³ in amount of implantation. After the mask 14 was removed, activation anneal was carried out in an atmosphere of argon at 1500°C for 30 minutes (f). As shown in FIG. 5(f), the high-concentration n-type layer 41 was formed in such a manner as to stick out slightly from the opposite sides of the n-type base region 4 that was formed by reversing (reverse-implanting) a part of the low-concentration p-type deposition film 32 to an n-type one. Since this layer 41 was formed by the same ion implantation, it equaled the n-type source layer 5 in impurity concentration and depth from the surface. Though the description by reference to a drawing will be omitted, the n-type layer 41 would continue to exist invariably in the remaining steps of the process for the fabrication (the process corresponding to FIG. 2b(g) through FIG. 2b(k)).
Since the n-type layer 41 and the n-type cathode layer 5 were simultaneously formed by ion implantation using the same photomask, the two channel regions 11 formed in the unit cell between these two layers could be given an equal length (equivalent to the so-called gate length) in a relative positional relation as designed in advance. Thus, the vertical MOSFET was enabled to lower the On-resistance thereof because the uniformity of electric current in motion while the device was ON was improved and the refinement of the cell could be attained owing to the effect of a kind of self-alignment action.

### [Embodiment 4]

FIG. 6 is a cross section of the SiC vertical MOSFET in Embodiment 4 of this invention. In the drawing, the sites bearing the same reference numerals as in FIG. 1 designate the same parts. The basic configuration of the cell is identical with that of Embodiment 1 of FIG. 1. This embodiment differed from Embodiment 1 in respect that the present device was made to form a p-n junction with the n-type layer 33 of FIG. 1 and that an insulation film 51 was interposed between the n-type layer 33 and the cathode electrode 9 in the place of the p⁺ layer 34 formed jointly over the p-type layer 32 and the p-type layer 31 and doped with aluminum in a high concentration of about 1 x 10¹⁹ cm⁻³. Consequently, it was rendered possible to prevent the n-type layer and the cathode electrode from forming a shirt circuit and decrease the leak pass of electric current in the state of voltage inhibition. This configuration can be applied to the cell configuration of Embodiments 2 and 3.
In the configurations of the unit cell of the vertical MOSFET illustrated in Embodiments 1 through 4 of this invention, the source electrode 9 was depicted as spanned between itself and the gate electrode 7 via the interlayer insulation film 8. This invention, however, does not need to be limited to this configuration, but is only required to have the source electrode contact the exposed parts of the surfaces of the source layer 5, p-type layer 32 and p-type layer 31 with low resistance. In all the embodiments, the gate oxide film 6 and the gate electrode 7 were invariably depicted as coating the whole surface of the n-type base region 4 formed by being reverse-implanted from the p type to the n type in consequence of ion implantation. The configuration having the gate oxide film and the gate electrode in this part deleted partly or wholly and the configuration having the gate oxide film formed in a thickness larger than the surface part of the channel region 11 do not deprive this invention of its operational effect. Furthermore, this invention can be applied even to the MOSFET of the so-called embedded channel configuration that is adapted to enhance channel conduction by implementing the n-type impurity ion implantation thinly in the surface of the p-type layer 32 fated to transform into the channel region 11.

The SiC vertical MOSFET described in the foregoing embodiments of this invention covered no specification as to the orientation of the crystal face of the SiC crystal substrate 1. It nevertheless can be applied to any of the (0001) face (commonly called silicon face) substrate generally in wide use, the (1120) face substrate, the (0001) face (commonly called carbon face) substrate, and the substrate having a surface parallel to the faces resulting from imparting slight OFF angles to such faces. The {0001) face (carbon face) substrate and the surface substrate parallel to the face resulting from imparting a slight OFF angle to that face, however, prove to be most suitable for acquiring a vertical MOSFET exhibiting high voltage and low On-resistance because they are disposed to enhance the compressive electric field strength in the neighborhood of the voltage inhibition junction and as well enhance the electron mobility in the channel region.
While this invention has been described by reference to the illustrated embodiments, this invention does not need to be limited to any of the embodiments described above, but allows embracing other configurations that can be easily altered by any person of ordinary skill in the art within the scope of the appended claims.

## Claims

1. A semiconductor device comprising:
a first conduction-type silicon carbide substrate (1);
a first deposition film (2) made of a first conduction-type silicon carbide and formed on the first conduction-type silicon carbide substrate;
a second deposition film (33) made of a first conduction-type silicon carbide and formed on the first deposition film;
a third deposition film (32) made of a second conduction-type silicon carbide and formed on the second deposition film;
a first conduction-type base region (4) and a second conduction-type gate region (11) formed selectively in said third deposition film;
a gate electrode (7) formed on a surface of at least said second conduction-type gate region via a gate insulation film (6);
a first conduction-type high-concentration source region (5) formed selectively in said second conduction-type gate region (11);
a drain electrode (10) connected with low resistance to a surface of said first conduction-type silicon carbide substrate (1);
a second conduction-type high-concentration gate layer (31) interposed between said first deposition film (2) and said second deposition film (33); and
a source electrode (9) connected with low resistance to a surfaces of said high-concentration source region (5) and said high-concentration gate layer (31);
wherein said second conduction-type high-concentration gate layer has a partially depletion part (24), said second deposition film (33) directly contacts said first deposition film (2) in said partially depletion part (24), and said first conduction-type base region (4) in said third deposition film (32) directly contacts said second deposition film (33) in a region to which said partially depletion part (24) is projected.

2. A semiconductor device according to claim 1, wherein a part in which said second conduction-type gate region (11) selectively formed in said third deposition film (32) contacts said gate insulation film (6) has a second conduction-type impurity concentration of 2 x 10 cm⁻³ or less.

3. A semiconductor device according to claim 1, wherein the high-concentration gate layer (31) of said second conduction-type layer is formed in said first deposition film (2).

4. A semiconductor device according to claim 1, wherein said second conduction-type high-concentration gate layer (3 1) is formed of a fourth deposition film formed on said first deposition film (2) and made of high-concentration second conduction-type silicon carbide.

5. A method for the fabrication of the semiconductor device set forth in claim 1, comprising the steps of:
forming said second conduction-type high-concentration gate layer (31) partially on said first deposition film (2);
forming said second deposition film (33) of said first conduction type on said first deposition film (2) exposed in said partial depletion part (24);
further forming thereon said third deposition film (32) of said second conduction type; and
selectively performing first conduction-type impurity ion implantation through a surface of said third deposition film (32) in a region to which said partial depletion part is projected till said second deposition film (33), thereby forming said first conduction-type base region (4).

6. A method according to claim 5, wherein said second conduction-type high-concentration gate layer (31) is selectively formed on the surface of said first deposition film (2) by second conduction-type impurity ion implantation of high-concentration and said second deposition film (33) is formed thereon, said third deposition film (32) of said second conduction type is further formed thereon, and said first conduction-type impurity ion implantation is selectively performed for the purpose of forming said first conduction-type base region (4) in said third deposition film.

7. A method according to claim 5, wherein said fourth deposition film (31) is formed on said first deposition film (2), a trench is formed through the surface of said fourth deposition film till said first deposition film (2), said second deposition film (33) is formed on said fourth deposition film (31) and said trench, said third deposition film (32) of said second conduction type is further formed thereon, and said first conduction-type impurity ion implantation is selectively performed for the purpose of forming said first conduction-type base region (4) in said third deposition film.

8. A semiconductor device according to claim 1, further comprising a first conduction-type high-concentration layer (41) selectively formed by ion implantation simultaneously in a same impurity concentration to a same depth with said first conduction-type high-concentration source region (5) in said first conduction-type base region (4) and a peripheral part thereof in a region to which said partial depletion part (24) in said third deposition film (32) is projected.

9. A semiconductor device according to claim 1, further comprising a region (34) formed by second conduction-type ion implantation in high concentration intervening between said second deposition film (33) and said source electrode (9) and contacting said source electrode (9) in low resistance.

10. A semiconductor device according to claim 1, further comprising an insulation film (51) intervening between said second deposition film (33) and said source electrode (9).

11. A semiconductor device according to claim 1, wherein the surface of said first conduction-type silicon carbide substrate (1) has a crystallographic face index that is approximately parallel to the {0001} face (carbon face).
